(19) Europäisches Patentamt
European Patent Office
Office européen des brevets

(11) EP 1 624 500 B1

(12) **EUROPÄISCHE PATENTSCHRIFT**

(45) Veröffentlichungstag und Bekanntmachung des Hinweises auf die Patenterteilung:
**16.03.2016 Patentblatt 2016/11**

(51) Int Cl.:
***H01L 51/30*** *(2006.01)* *H01L 51/42* *(2006.01)*
*H01L 51/50* *(2006.01)*

(21) Anmeldenummer: **04030606.0**

(22) Anmeldetag: **23.12.2004**

(54) **Spiro-Bifluoren Verbindungen als organisches Halbleiter-Matrixmaterial**

Spiro bifluorene compounds as organic semiconductor matrix materials

Compositions de spiro bifluorène utilisées comme matériau matriciel à semiconducteur organique

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **05.08.2004 DE 102004037897**

(43) Veröffentlichungstag der Anmeldung:
**08.02.2006 Patentblatt 2006/06**

(73) Patentinhaber: **Novaled GmbH**
**01307 Dresden (DE)**

(72) Erfinder:
- **Pfeiffer, Martin, Dr.**
  **01127 Dresden (DE)**
- **Blochwitz-Nimoth, Jan, Dr.**
  **01097 Dresden (DE)**
- **Lux, Andrea, Dr.**
  **01277 Dresden (DE)**
- **Salbeck, Josef, Prof. Dr.**
  **34260 Kaufungen (DE)**

(74) Vertreter: **Bittner, Thomas L.**
**Boehmert & Boehmert**
**Anwaltspartnerschaft mbB**
**Patentanwälte Rechtsanwälte**
**Pettenkoferstrasse 20-22**
**80336 München (DE)**

(56) Entgegenhaltungen:
**EP-A- 0 676 461** **DE-A1- 4 446 818**
**US-B1- 6 747 287**

- **ZHOU X ET AL: "ENHANCED HOLE INJECTION INTO AMORPHOUS HOLE-TRANSPORT LAYERS OF ORGANIC LIGHT-EMITTING DIODES USING CONTROLLED P-TYPE DOPING" ADVANCED FUNCTIONAL MATERIALS, WILEY INTERSCIENCES, WIENHEIM, DE, Bd. 11, Nr. 4, August 2001 (2001-08), Seiten 310-314, XP001042080 ISSN: 1616-301X**
- **HUNG L S ET AL: "Recent progress of molecular organic electroluminescent materials and devices" MATERIALS SCIENCE AND ENGINEERING R: REPORTS, ELSEVIER SEQUOIA S.A., LAUSANNE, CH, Bd. 39, Nr. 5-6, 1. Dezember 2002 (2002-12-01), Seiten 143-222, XP004391352 ISSN: 0927-796X**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft ein elektronisches Bauelement in Form einer organischen lichtemittierenden Diode (OLED) oder einer organischen solarzelle mit einem organischen Halbteiterbauelement.

Es ist bekannt, organische Halbleiter durch Dotierung hinsichtlich ihrer elektrischen Eigenschaften, insbesondere ihrer elektrischen Leitfähigkeit, zu verändern, wie dies auch bei organischen Halbleitern wie Siliziumhalbleitern der Fall ist.

Hierbei wird durch Erzeugung von Ladungsträgern in einem Matrixmaterial eine Erhöhung der zunächst recht niedrigen Leitfähigkeit sowie, je nach Art des verwendeten Dotanden, eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht.

Zum Dotieren solcher organischen Halbleiter sind starke Elektronen-Akzeptoren wie Tetracyanoquinondimethan (TCNQ) oder 2,3,5,6-Tetrafluoro-tetracyano-1,4-benzoquinondimethan (F4-TCNQ) bekannt geworden, siehe M. Pfeiffer, A. Beyer, T. Fritz, K. Leo, Appl.Phys.Lett., 73 (22), 3202-3204 (1998) und J. Blochwitz, M. Pfeiffer, T. Fritz, K. Leo, Appl.Phys.Lett., 73 (6), 729-732 (1998). Diese erzeugen durch Elektronentransferprozesse in elektronendonatorartigen Basismaterialien (Löchertransportmaterialien) sogenannte Löcher, durch deren Anzahl und Beweglichkeit sich die Leitfähigkeit des Matrixmaterials mehr oder weniger signifikant verändert.

Als Matrixmaterialien sind beispielsweise Starburst-Verbindungen bekannt, wie 4,4',4"-Tris(diphenylamino)triphenylamin (TDATA), 4,4'4"-Tris(3-methylphenyl-phenylamino)triphenylamin (m-MTDATA) und N,N,N',N'-Tetrakis(4-methoxyphenyl)-benzidin (MeO-TPD).

Die chemische Struktur der oben genannten bekannten Matrixmaterialien ist im folgenden gezeigt:

| | | |
|---|---|---|
| 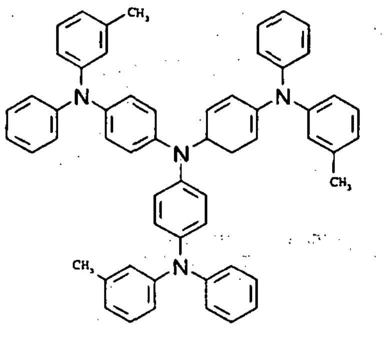<br>Starburst = m-MTDATA 4,4',4"-tris(3-Methylphenylphenylamino) Triphenylamin | 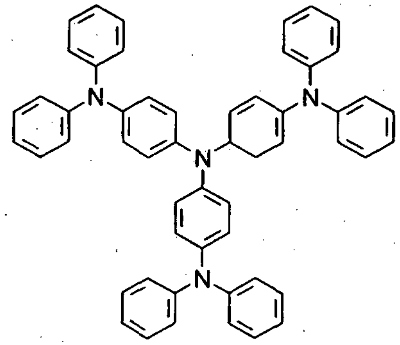<br>Starburst = TDATA 4,4',4"-tris(N,N-Diphenylamino) Triphenylamin | 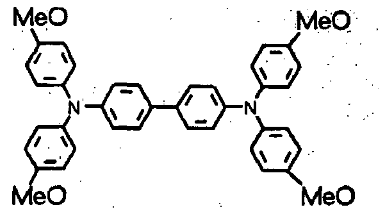 |
| TDATA | m-MTDATA | MeO-TPD |

Diese Verbindungen sind jedoch thermisch instabil, das heißt sie weisen eine geringe Glasübergangstemperatur auf und neigen bei geringen Temperaturen zur Kristallisation, was schließlich zu instabilen elektronischen Bauelementen führt.

Als Glasübergangstemperatur wird dabei die Temperatur angesehen, bei der bei einer raschen Abkühlung des Materials aus der Schmelze eine Bewegung der Moleküle aus kinetischen Gründen nicht mehr möglich ist und thermodynamische Parameter wie die Wärmekapazität oder der Ausdehnungskoeffizient plötzlich von typischen Flüssigkeitswerten auf typische Festkörperwerte übergehen. Die thermische Stabilität des Matrixmaterials ist insbesondere aus morphologischen Gründen beim Einsatz von organischen Halbleitermaterialien mit solchen Matrixmaterialien von Bedeutung, um die Ausbildung von Rauhigkeiten bei erhöhten Betriebstemperaturen in der üblichen Schichtstruktur solcher Halbleitermaterialien zu vermeiden. Desweiteren ist die thermische Stabilität von Bedeutung, um die Diffusion des Dotanden im Matrixmaterial einzuschränken.

Aus dem Stand der Technik sind auch thermisch stabile Matrixmaterialien, wie 2,2',7,7'-Tetrakis-(N,N-diphenylamino)-9,9'-spirobifluoren (Spiro-TAD), bekannt, welche jedoch aufgrund der Lage des Energieniveaus ihrer höchsten besetzten Molekülorbitale (HOMO) nicht dotierbar sind.

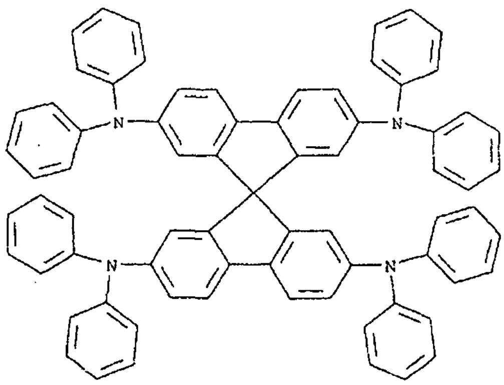

(Spiro-TAD)

X. Zhou et al., Adv. Func. Mater., 11, 310-314 (2001) beschreibt die Dotierung eines Lochleitermaterials, basierend auf einem aromatischen Amin (TDATA) mit einem organischen Dotanden ($F_4$-TCNQ), und die damit verbundenen Verbesserungen in den elektronischen Eigenschaften. Die Dotierung führt zu hohen Leitfähigkeiten der dotierten TDATA-Schichten. Die mehrschichtigen organischen lichtemittierenden Dioden (OLEDs) bestehen aus doppelten Lochtransportschichten von p-dotierten TDATA und dünneren Zwischenschichten aus Triphenyldiamin (TPD).

L.S. Hung et al., Mater. Sci. Eng., 39, 143-222 (2002) offenbart Spiro-verknüpfte Verbindungen, wie Spiro-mTPD, als Lochtransportmaterial in organischen lichtemittierenden Dioden (OLED). Die meta-substituierte Spiroverbindung Spiro-mTPDweist ein niedrig liegendes HOMO-Energieniveau auf, welches eine Dotierung dieser Verbindung mit einem Dotanden wie $F_4$-PCNQ unmöglich macht.

US 6,747,287 B1 offenbart die Verwendung eines organischen Matrixmaterial zur Herstellung eines organischen Halbleitermaterials (organischer Dünnfilmtransistor (OTFT)), wobei das organische Matrixmaterial eine Spiro-Bifluorenverbindung umfasst. Aus der Offenbarung ergibt sich jedoch keinerlei Hinweis, dass mit diesem Matrixmaterial eine Lochtransportschicht gebildet werden kann, die mit einem organischen Dotanden dotiert ist. Vielmehr ergibt sich für die aufgeführten Spiro-Verbindungen lediglich eine Dotierung mit Metallelementen und anorganischen Metallverbindungen, sowie Lewis-Säuren.

In U. Bach et al., Nature, 395, 583-585 (1998) wird die Verwendung von Spiro-Bifluoren-Verbindungen, wie OMeTAD, als amorphe organische Lochtransportmaterialien beschrieben. Diese werden in Solarzellen eingesetzt, welche aus einem Farbstoff-sensibilisierten mesoporösem Film von $TiO_2$ bestehen.

Der Erfindung liegt die Aufgabe zugrunde, ein elektrinisches Bauelement in Form einer organischen lichtemittierenden Diode (OLED) oder einer organischen Solarzelle mit einem organischen Halbleiterbauelement bereitzustellen, wobei das Matrixmaterial thermisch stabil und dotierbar ist, um Löchertransportschichten mit hoher Löcherleitfähigkeit für den Einsatz in organischen Halbleiterbauelementen bereitzustellen. Ferner sollen die organischen Matrixmaterialien aufdampfbar sein, um durch Co-Verdampfung im Vakuum mit einem starken organischen Elektronen-Akzeptor Schichten mit einer entsprechend hohen Löcherleitfähigkeit zu liefern.

Diese Aufgabe wird gelöst durch ein elektronisches Bauelement in Form einer organischen lichtemittierenden Diode (OLED) oder einer organischen Solarzelle mit einem organischen Halbleiterbauelement enthaltend eine Lochtransportschicht aus einem mit einem organischen Dotanden dotierten organischen Matrixmaterial, dadurch gekennzeichnet, dass das organische Matrixmaterial zumindest teilweise von einer Spiro-Bifluoren-Verbindung der Formel (I)

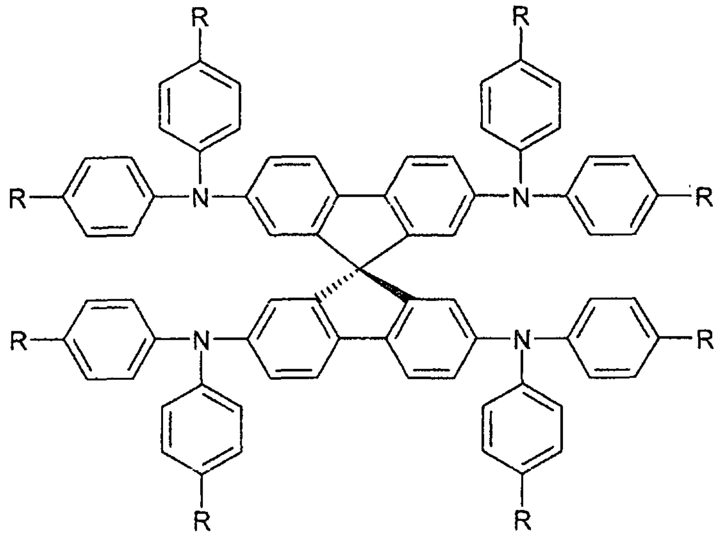

(I; R-Spiro-TAD)

und/oder der Formel (II)

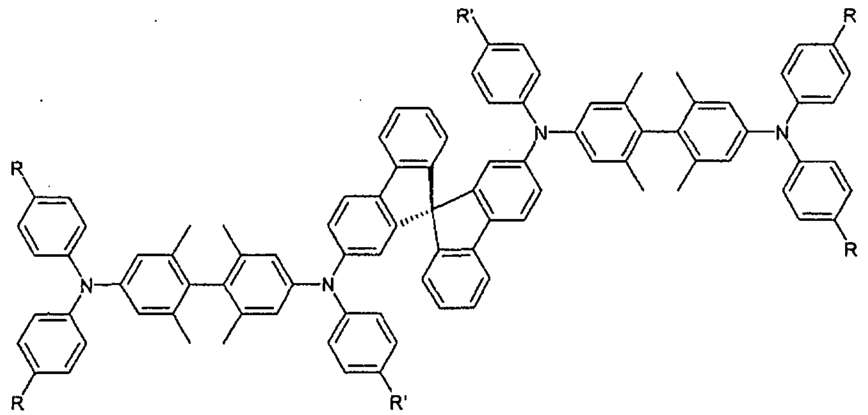

(II; Spiro-TM-TAD)

umfasst ist, wobei jedes R und/oder R' in Formel (I) und Formel (II) unabhängig ausgewählt ist aus der Gruppe bestehend aus Wasserstoff, Methyl, Ethyl, n-Propyl, iso-Propyl, n-Butyl, iso-Butyl, tert-Butyl, $NH_2$, $N(CH_3)_2$ und $NPh_2$, wobei nicht alle R in Formel (I) gleichzeitig Wasserstoffe sind und in Formel (II) R nicht Wasserstoff ist,
wobei die Glasübergangstemperatur des organischen Matrixmaterials mindestens 120°C beträgt und das höchste besetzte Molekülorbital (HOMO) des Matrixmaterials höchstens auf einem Energieniveau von 5,4 eV liegt.

Besonders bevorzugt ist, daß die Spiro-Bifluoren-Verbindung ausgewählt ist aus der Gruppe bestehend aus

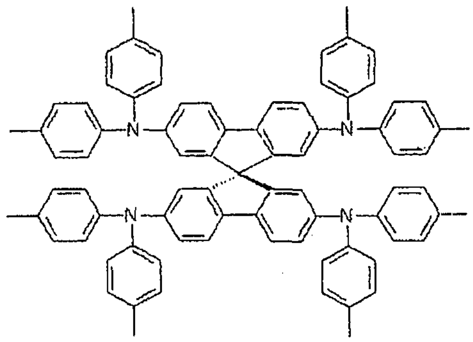

(Spiro-TTB);

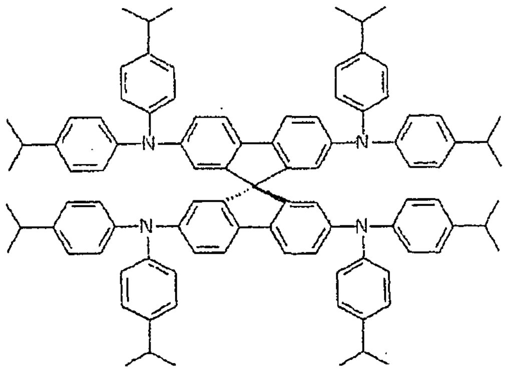

(Spiro-iPr-TAD);

und

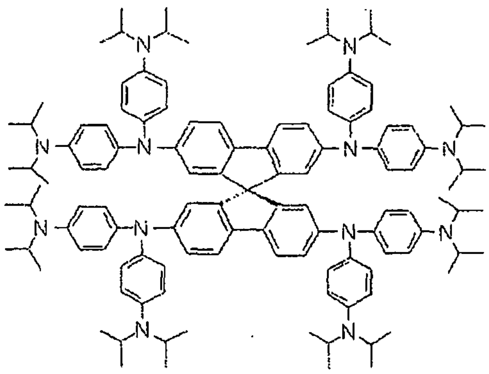

(Spiro-iPr$_2$N-TAD)

Ebenso bevorzugt ist, daß die Glasübergangstemperatur der Spiro-Bifluoren-Verbindung zwischen 120°C und 250°C liegt und das höchste besetzte Molekülorbital der Verbindung auf einem Energieniveau zwischen 4,5 eV und 5,4 eV, bevorzugt zwischen 4,8 eV und 5,2 eV liegt.

Ebenfalls ist bevorzugt, daß der Dotand 2,3,5,6-Tetrafluoro-7,7,8,8-tetracyanoquinodimethan oder ein Derivat desselben ist. Jedoch sind weitere Dotanden mit ähnlicher Akzeptorwirkung und gleicher oder größerer molekularer Masse möglich, siehe z.B DE10357044.6. Besonders bevorzugt ist, daß das molare Dotierungsverhältnis von Dotand zu Matrixmaterial zwischen 1:1 und 1:10.000 beträgt.

Der Erfindung liegt die überraschende Erkenntnis zugrunde, daß durch ein elektronisches Bauelement nach Anspruch 1 thermisch stabile und dotierte Löchertransportschichten geliefert werden. Das elektronische Bauelement stellt Löchertransportmaterialien bereit, welche aufdampfbar sind, so daß sie durch Co-Verdampfung im Vakuum mit einem starken organischen Elektronen-Akzeptor zu Schichten mit einer hohen Löcherleitfähigekeit führen.

Bei dem elektronischen Bauelement wird ein stabiler, einfach positiv geladener Kationenzustand des Löchertransportmaterials erzielt.

Weitere Vorteile und Merkmale der vorliegenden Erfindung ergeben sich aus der folgenden detaillierten Beschreibung beispielhafter elektronischer Bauelemente sowie den beigefügten Zeichnungen, in denen

Fig. 1 für eine Transportschicht des organischen Matrixmaterials Spiro-TTB (dotiert mit F4-TCNQ) die Abhängigkeit des Querstromes von der Schichtdicke zeigt;

Fig. 2 für eine Transportschicht des organischen Matrixmaterials Spiro-iPr-TAD (dotiert mit F4-TCNQ) die Abhängigkeit des Querstroms von der Schichtdicke zeigt; und

Fig. 3 die Leuchtdichte-Spannungs- und Stromeffizienz-Spannungskennlinien einer organischen Licht emittierenden Diode mit dotierten Transportschichten und Spiro-TTB (dotiert mit F4 TCNQ) als p-Dotand zeigt.

Beispiele

**A. Herstellung von 2,2',7,7'-Tetrakis-(*N,N*-di-*p*-methylphenylamino)-9,9'-spirobifluoren (Spiro-TTB)**

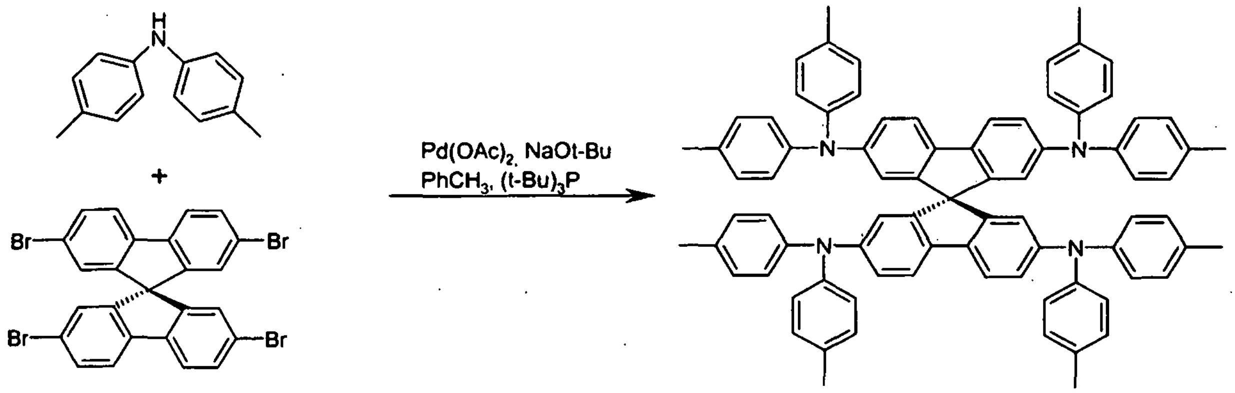


2,2',7,7'-Tetrabrom-9,9'-spirobifluoren (10 g, 15.8 mmol), Di-*p*-tolylamin (14.2 g, 72.1 mmol) und Natrium-*tert*-butylat (9.6 g, 100 mmol) werden in 100 ml wasserfreiem Toluol unter Stickstoff 1 h bei 60 °C gerührt. Anschließend werden Tri-*tert*-butylphosphin (200 mg, 1.0 mmol, 6.3 % bezogen auf Tetrabromspirobifluoren) und Palladium(II)acetat (92 mg, 0.4 mmol, 2.6 % bezogen auf Tetrabromspirobifluoren) zugefügt und die Reaktionsmischung unter Stickstoff zum Rückfluss erhitzt. Der Verlauf der Reaktion wird dünnschichtchromatographisch verfolgt (Laufmittel 50 % Hexan in Dichlormethan). Nach 2.5 h ist im DC kein Edukt mehr nachweisbar. Die Reaktionsmischung wird abgekühlt, mit einer Lösung von 100 mg KCN in 20 ml Wasser versetzt und noch 1 h bei 60 °C gerührt. Nach Abkühlen auf Raumtemperatur werden die Phasen getrennt und die organische Phase mit Natriumsulfat getrocknet und das Lösungsmittel entfernt. Das Rohprodukt wird zweimal aus Dioxan umkristallisiert und anschließend aus wenig Dichlormethan in Hexan umgefällt und im Vakuum getrocknet.

Ausbeute: 15.0 g (13.8 mmol, 87 % d. Th.) leicht grünliches Pulver.

$^{1}$H-NMR (500 MHz, $CDCl_3$ + Hydrazinhydrat): 7.40 (d, 1H, J=7.8), 7.00 (d, 4H, J=8.3), 6.88 (d, 4H, J=8.3), 6.85 (dd, 1H, J=8.3, J=2.0), 6.67 (d, 1H, J=2.0), 2.30 (s, 6H).

$^{13}$C-NMR (127.5 MHz, $CDCl_3$ + Hydrazinhydrat): 149.8, 146.7, 145.3, 136.1, 131.5, 129.5, 124.0, 123.2, 119.9, 119.3, 65.3, 20.6.

**B. Herstellung von 2,2',7,7'-Tetrakis-(N,N-di-p-isopropylphenylamino)-9,9'-spirofluoren (Spiro-iPr-TAD)**

**4-Isopropyliodbenzol**

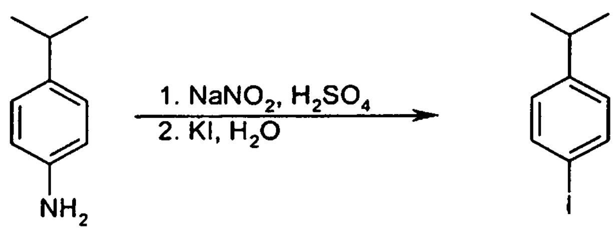


4-Isopropylanilin (49.5 g, 366 mmol) werden in 200 ml dest. Wasser suspendiert und langsam bei Eiskühlung mit 200 ml halbkonzentrierter Schwefelsäure versetzt. Anschließend wird eine Lösung von Natriumnitrit (25.5 g, 370 mmol) in 200 ml dest. Wasser so zugetropft, dass die Temperatur nicht über 2 °C steigt. Nach Beendigung des Zutropfens wird noch 20 min. bei 2 °C gerührt. Die erhaltene, klare rötliche Diazoniumsalzlösung wird nun durch einen Filter zu einer Lösung von Kaliumiodid (135.0 g, 813 mmol) in 200 ml dest. Wasser gegeben. Die Reaktionsmischung wird für 1h bei 80 °C gerührt. Hierbei färbt sich die Lösung unter starker Gasentwicklung schwarz und eine ölige organische Phase scheidet sich ab. Nach Abkühlung wird die organische Phase abgetrennt und die wässrige Phase noch viermal mit je 100 ml Ether ausgeschüttelt. Die vereinigten organischen Phasen werden mit verdünnter Natronlauge und dest. Wasser gewaschen und über Natriumsulfat getrocknet. Nach Entfernung des Lösungsmittels wird das Rohprodukt im Membranpumpenvakuum destilliert. Das leicht rötliche Zielprodukt geht bei einer Temperatur von 100-105 °C (15 mbar) über.

Ausbeute: 75.3 g (310 mmol, 83 % d. Th.) leicht rötliche Flüssigkeit.

$^1$H-NMR (500 MHz, $CDCl_3$): 7.60 (d, 2H, J=8.3), 6.98 (d, 2H, J=8.3), 2.85 (q, 1H, J=6.8), 1.22 (d, 6H, J=6.8).

$^{13}$C-NMR (127.5 MHz, $CDCl_3$): 148.4, 137.3, 128.6, 90.6, 33.7, 23.8.

**N-Acetyl-4-isopropylanilin**

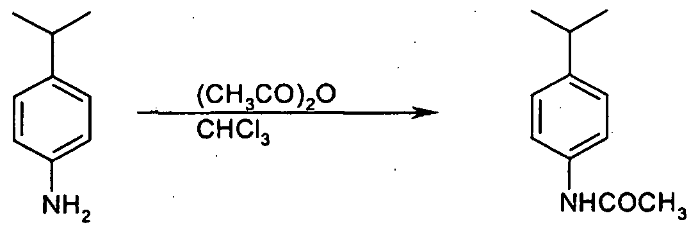


Zu einer Lösung von 4-Isopropylanilin (17.2 g, 127 mmol) in 80 ml Chloroform wird langsam Essigsäureanhydrid (26.0 g, 254 mmol) zugetropft. Hierbei tritt eine starke Erwärmung des Reaktionsgemisches ein. Nach Beendigung des Zutropfens wird noch 2 h bei Raumtemperatur gerührt. Die Reaktionsmischung wird zur Trockene eingeengt und der erhaltene, rötlich weiße Feststoff aus Hexan umkristallisiert.

Ausbeute: 21.1 g (120 mmol, 94 % d. Th.) weißer Feststoff.

$^1$H-NMR (500 MHz, $CDCl_3$): 7.88 (s, 1H), 7.40 (d, 2H, J=8.3), 7.14 (d, 2H, J=8.3), 2.86 (q, 1H, J=6.8), 1.21 (d, 6H, J=6.8).

$^{13}$C-NMR (127.5 MHz, $CDCl_3$): 168.6, 144.9, 135.6, 126.7, 120.2, 33.5, 24.3, 23.9.

Schmelzpunkt: 107 °C (Literatur (Dyall, Aus. J. Chem. 17, 1964, 419): 104-105 °C).

***N*-Acetyl-*N,N*-di-(4-isopropylphenyl)-amin**

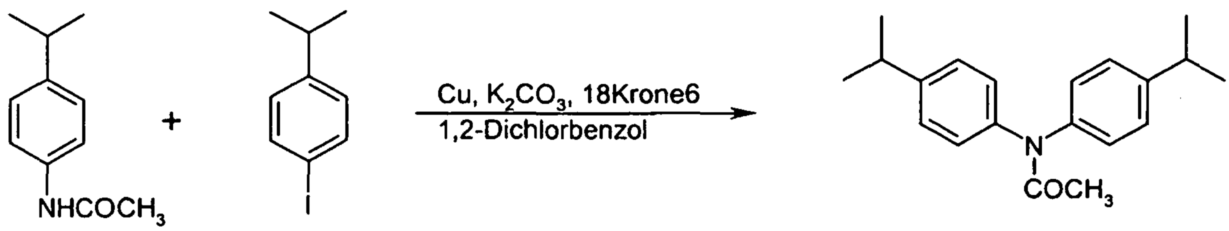

4-Isopropyliodbenzol (29.2 g, 118 mmol), *N*-Acetyl-4-isopropylanilin (21.0 g, 118 mmol), Kupferpulver (15.0 g, 237 mmol), Kaliumcarbonat (65.4 g, 474 mmol) und 18-Krone6 (2.9 g, 12 mmol) werden in 200 ml 1,2-Dichlorbenzol zum Rückfluss erhitzt. Die Reaktion wird dünnschichtchromatographisch verfolgt (Laufmittel: 10 % THF in Dichlormethan). Nach 48 h wird die noch heiße Reaktionsmischung filtriert, der Filterrückstand gut ausgewaschen und die Lösungsmittel am Rotationsverdampfer entfernt. Das Rohprodukt wird an Kieselgel mit 10 % THF in Dichlormethan chromatographiert. Die Produktfraktionen werden zur Trockene eingeengt, aus Hexan umkristallisiert und im Vakuum getrocknet.

Ausbeute: 14.31 g (48 mmol, 41 % d. Th.) leicht bräunlicher Feststoff.

$^1$H-NMR (500 MHz, $CDCl_3$): 7.21 (m, 8H), 2.90 (s (br.), 2H), 2.04 (s, 3H), 1.23 (s (br.), 12H).

*N,N*-Di-(4-isopropylphenyl)-amin

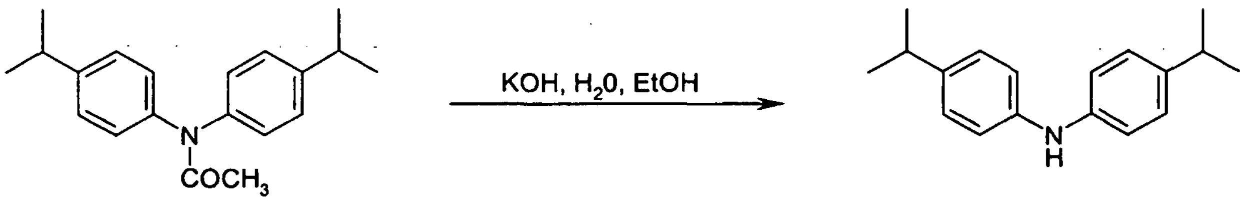


*N*-Acetyl-*N,N*-di-(4-isopropylphenyl)-amin (5.4 g, 18.4 mmol) werden in 100 ml 20%iger wässrigem Ethanol zum Rückfluß erhitzt. Die Reaktion wird dünnschichtchromatographisch verfolgt. Nach 30 h ist im DC kein Edukt mehr nachweisbar. Die ethanolische Lösung wird in dest. Wasser eingegossen, der bräunliche Niederschlag abgenutscht, in Dichlormethan gelöst und mit Natriumsulfat getrocknet. Die Lösung wird eingeengt und über eine kurze Kieselgelsäule mit 50 % Dichlormethan in Hexan chromatographiert. Die Produktfraktionen werden zur Trockene eingeengt und das Produkt im Vakuum getrocknet.

Ausbeute: 4.0 g (16 mmol, 86 % d. Th.) leicht bräunlicher Feststoff.

$^1$H-NMR (500 MHz, $CDCl_3$): 7.12 (d, 4H, J=8.3), 6.99 (d, 4H, J=8.3), 5.55 (s (br.), 1H), 2.86 (q, 2H, J=6.8), 1.24 (d, 12H, J=6.8).

$^{13}$C-NMR (127.5 MHz, $CDCl_3$): 141.3, 127.1, 117.7, 33.4, 24.1.

**2,2',7,7'-Tetrakis-(*N,N*-di-*p*-isopropylphenylamino)-9,9'-spirobifluoren (Spiro-iPr-TAD)**

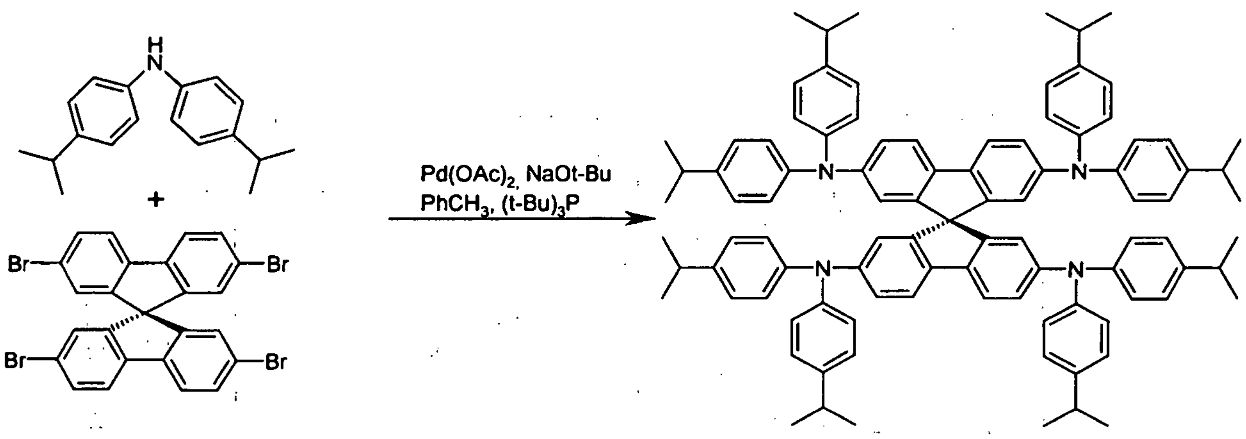


2,2',7,7'-Tetrabrom-9,9'-spirobifluoren (1.7 g, 2.6 mmol), *N,N*-Di-4-isopropylphenylamin (3.0 g, 12.0 mmol) und Natrium-*tert*-butylat (1.6 g, 17 mmol) werden in 100 ml wasserfreiem Toluol unter Stickstoff 1 h bei 60 °C gerührt. Anschließend werden Tri-*tert*-butylphosphin (4.8 mg, 0.24 mmol, 9.2 % bezogen auf Tetrabromspirobifluoren) und Palladium(II)acetat (27 mg, 0.12 mmol, 4.6 % bezogen auf Tetrabromspirobifluoren) zugefügt und die Reaktionsmischung unter Stickstoff zum Rückfluss erhitzt. Der Verlauf der Reaktion wird dünnschichtchromatographisch verfolgt (Laufmittel 20 % Dichlormethan in Hexan). Nach 3.5 h ist im DC kein Edukt mehr nachweisbar. Die Reaktionsmischung wird abgekühlt, mit einer Lösung von 100 mg KCN in 20 ml Wasser versetzt und noch 1 h bei 60 °C gerührt. Nach Abkühlen

auf Raumtemperatur werden die Phasen getrennt und die organische Phase mit Natriumsulfat getrocknet und das Lösungsmittel entfernt. Das Rohprodukt wird zweimal aus Dioxan umkristallisiert und anschließend im Vakuum getrocknet.

Ausbeute: 2.8 g (2.1 mmol, 81 % d.Th.) leicht gelbliches, feinkristallines Pulver.

$^1$H-NMR (500 MHz, $CDCl_3$): 7.41 (d, 1H, J=8.3), 7.05 (d, 4H, J=8.3), 6.90 (m, 5H), 6.72 (s (br.) 1H), 2.85 (q, 2H, J=6.8), 1.24 (d, 12H, J=6.8).

$^{13}$C-NMR (127.5 MHz, $CDCl_3$): 150.7, 147.5, 146.3, 143.3, 137.2, 127.6, 125.3, 123.8, 120.8, 120.7, 66.2, 34.1, 24.8.

Tg: 144 °C, Tk: 166 °C, Tm: 363 °C.

Die beiden organischen Matrixmaterialien Spiro-TTB und Spiro-iPr-TAD wurden jeweils mit F4-TCNQ dotiert und in Leitfähigkeitsmessungen getestet. Dabei wurde über zwei ca. 5 mm breite Kontakte (aus Indium-Zinn-Oxid, ITO), welche in ca. 1 mm Abstand zueinander auf einem Glassubstrat aufgebracht sind, die dotierte Schicht im Vakuum durch Coverdampfung aufgebracht. Die Kontakte waren nach außen zu einem Strom-Spannungsmeßgerät verbunden, wodurch der Querstrom bei einer festen angelegten Spannung gemessen werden konnte. Aus diesem Querstrom errechnet sich dann die Leitfähigkeit der Schicht nach einem einfachen ohmschen Zusammenhang. Die Leitfähigkeit kann anhand folgender Gleichung ermittelt werden:

$$\text{Leitfähigkeit} = (\text{Querstrom} * \text{Abstand})/(\text{Breite} * \text{Schichtdicke})$$

Die Fig. 1 und 2 zeigen jeweils die Zunahme des Querstroms mit der Schichtdicke für die beiden dotierten Matrixmaterialien. Die Leitfähigkeit einer 50 nm dicken, mit 2,5% F4-TCNQ-dotierten Schicht aus Spiro-TTB beträgt ca. 1,6E-5S/cm, während die Leitfähigkeit einer 50 nm dicken, mit 5% F4-TCNQ-dotierten Schicht aus Spiro-iPr-TAD ca. 8E-7S/cm beträgt.

Eine Ausführungsform eines erfindungsgemäßen elektronischen Bauelements in Form einer OLED mit einem organischen Halbleiterbauelement kann hergestellt werden und umfaßt bei normaler, durch das Substrat emittierender Bauweise die folgende Schichtanordnung:

1. Trägersubstrat: Glas,

2. untere Elektrode (Anode A): ITO,

3. p-dotierte, Löcher injizierende und transportierende Schicht: Spiro-TTB: F4-TCNQ (2,5% molare Dotierungskonzentration),

4. dünne löcherseitige Zwischenschicht aus einem Material, dessen Bandlagen zu den Bandlagen der sie umgebenden Schichten passen: Spiro-TAD,

5. Licht emittierende Schicht (evt. mit Emittertafarbstoff dotiert): TCTA (4,4',4"-Tris(N-carbazolyl)-triphenylamin): Irppy 3 (fac-Tris(2-phenylpyrridin)iridium),

6. dünne elektronenseitige Zwischenschicht aus einem Material, dessen Bandlagen zu den Bandlagen der sie umgebenden Schichten passen: BPhen (4,7-Diphenyl-1,10-phenanthrolin),

7. n-dotierte, Elektronen injizierende und transportierende Schicht: BPhen dotiert mit Caesium (ca. 1:1 molar Konzentration),

8. obere Elektrode (Kathode K): Aluminium, und

9. Kapselung zum Ausschluß von Umwelteinflüßen: Deckglas

Eine so hergestellte organische Licht emittierende Diode wurde bezüglich der Leuchtdichte-Spannungs- und Stromeffizienz-Spannungskennlinien untersucht, welche Ergebnisse in Fig. 3 gezeigt sind. Dank der Dotierung der organischen Löchertrannsportschicht zeigt diese eine sehr steile Strom-Spannungs-Kennlinie und damit eine sehr steile Leuchtdichte-Spannungskennlinie (linke Achse). Die Leuchtdichten von 100cd/m2 und 1000cd/m2 werden bei Spannungen von 2,75V und 3,1 V erreicht. Wegen der idealen Anordnung der dotierten Löcher- und Elektronentransportschichten und der zwei Zwischenschichten sind die Stromeffizienzen der Lichterzeugung ebenfalls sehr groß und über einen weiten Helligkeitsbereich konstant: 46cd/A und 45cd/A. Aufgrund der stabilen Löchertransportschicht kann diese OLED stabil bei höheren Temperaturen (bis über 100°C) betrieben werden, ohne daß es zu einem Abfall der optoelektronischen Eigenschaften kommt.

In der vorstehenden Beschreibung, in den Ansprüchen, sowie in den Zeichnungen offenbarten Merkmale der Erfindung können sowohl einzeln als auch in jeder beliebigen Kombination für die Verwirklichung der Erfindung in ihren verschiedenen Ausführungsformen wesentlich sein.

## Patentansprüche

1. Elektronisches Bauelement in Form einer organischen lichtemittierenden Diode (OLED) oder einer organischen Solarzelle mit einem organischen Halbleiterbauelement enthaltend eine Lochtransportschicht aus einem mit einem organischen Dotanden dotierten organischen Matrixmaterial, **dadurch gekennzeichnet, dass** das organische Matrixmaterial zumindest teilweise von einer Spiro-Bifluoren-Verbindung der Formel (I)

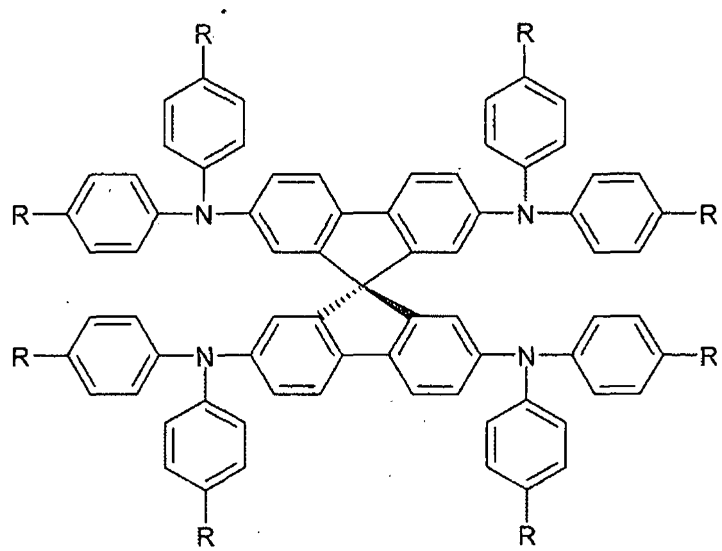

(I; R-Spiro-TAD)

und/oder der Formel (II)

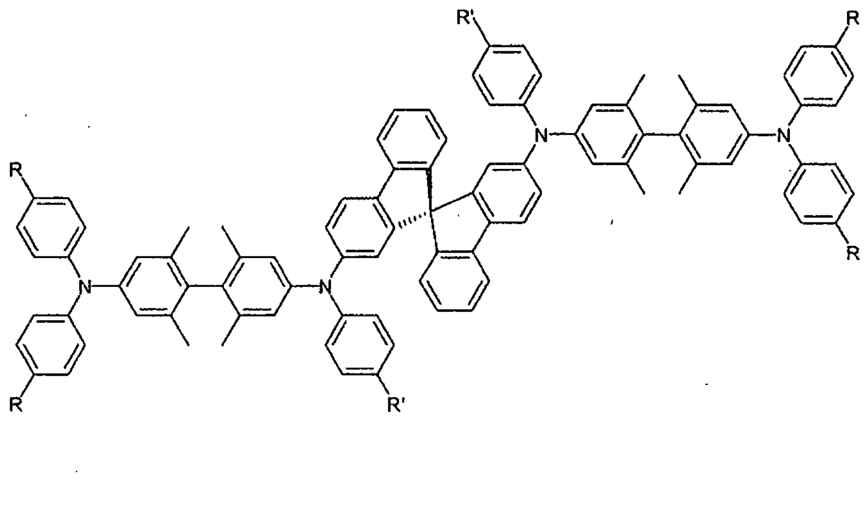

(II; Spiro-TM-TAD)

umfasst ist, wobei jedes R und/oder R' in Formel (I) und Formel (II) unabhängig ausgewählt ist aus der Gruppe

bestehend aus Wasserstoff, Methyl, Ethyl, n-Propyl, iso-Propyl, n-Butyl, iso-Butyl, tert-Butyl, $NH_2$, $N(CH_3)_2$ und $NPh_2$, wobei nicht alle R in Formel (I) gleichzeitig Wasserstoffe sind und in Formel (II) R nicht Wasserstoff ist, wobei die Glasübergangstemperatur des organischen Matrixmaterials mindestens 120°C beträgt und das höchste besetzte Molekülorbital (HOMO) des Matrixmaterials höchstens auf einem Energieniveau von 5,4 eV liegt.

2. Elektronisches Bauelement nach Anspruch 1, **dadurch gekennzeichnet, dass** die Spiro-Bifluoren-Verbindung ausgewählt ist aus der Gruppe bestehend aus

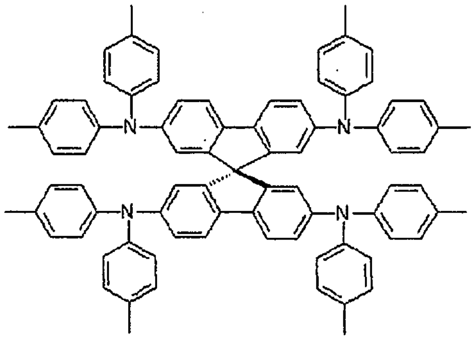

(Spiro-TTB);

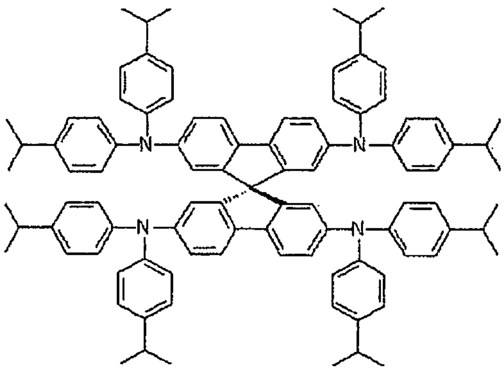

(Spiro-iPr-TAD);

und

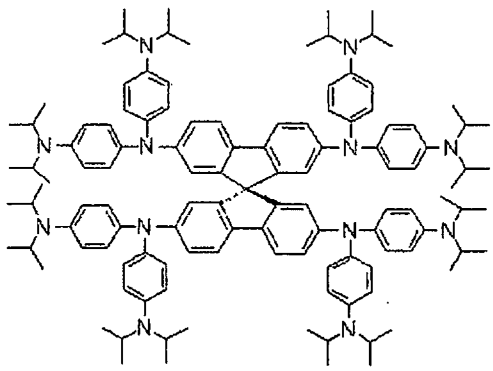

(Spiro-iPr$_2$N-TAD)

3. Elektronisches Bauelement nach Anspruch 1 oder 2, **dadurch gekennzeichnet, dass** die Glasübergangstemperatur der Spiro-Bifluoren-Verbindung zwischen 120°C und 250°C liegt und das höchste besetzte Molekülorbital der Verbindung auf einem Energieniveau zwischen 4,5 eV und 5,4 eV, bevorzugt zwischen 4,8 eV und 5,2 eV liegt.

4. Elektronisches Bauelement nach einem der vorangehenden Ansprüche, **dadurch gekennzeichnet, dass** der Dotand 2,3,5,6-Tetrafluor-7,7,8,8-tetracyanoquinodimethan oder ein Derivat desselben ist.

**5.** Elektronisches Bauelement nach einem der vorangehenden Ansprüche, **dadurch gekennzeichnet, dass** das molare Dotierungsverhältnis von Dotand zu Matrixmaterial zwischen 1:1 und 1:10.000 beträgt.

## Claims

**1.** Electronic component in the form of an organic light-emitting diode (OLED) or an organic solar cell having an organic semiconductor component containing a hole transport layer of an organic matrix material doped with an organic dopant, **characterized in that** the organic matrix material is comprised at least partly of a spiro-bifluorene compound of formula (I)

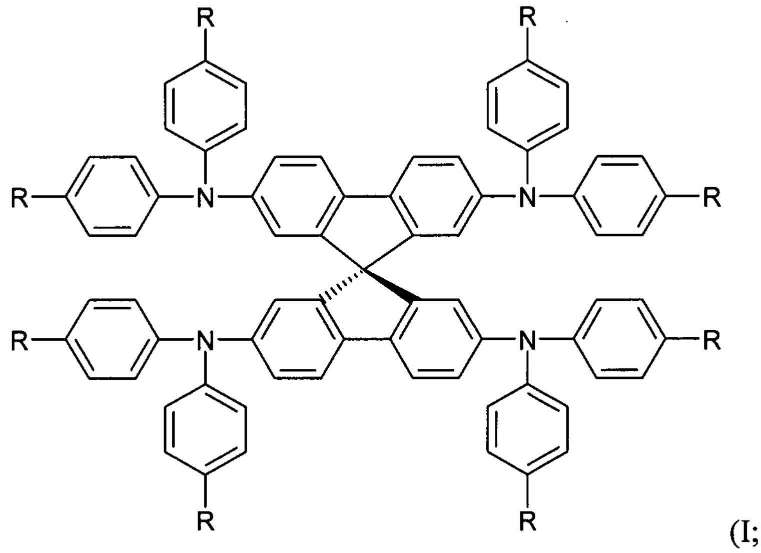

(I; R-Spiro-TAD)

and/or formula (II)

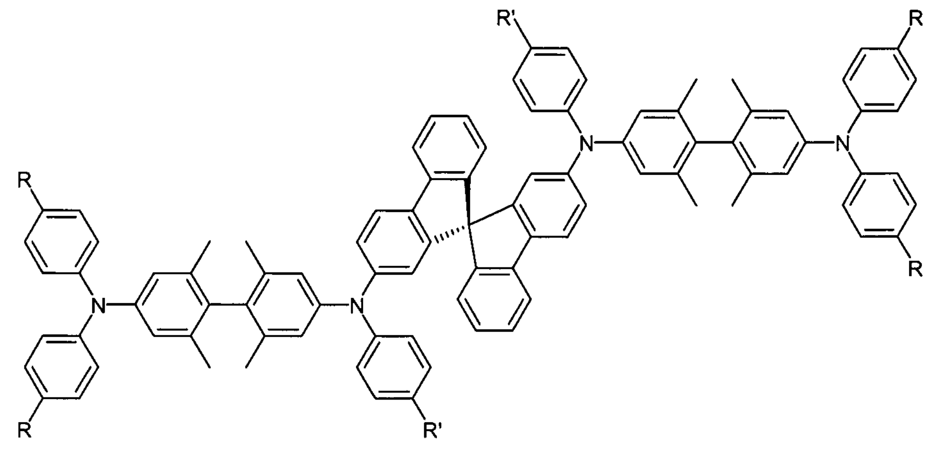

(II; Spiro-TM-TAD)

wherein each R and/or R' in formula (I) and formula (II) is independently selected from the group consisting of hydrogen, methyl, ethyl, n-propyl, iso-propyl, n-butyl, iso-butyl, tert-butyl, $NH_2$, $N(CH_3)_2$ and $NPh_2$, wherein not all of R in formula (I) are simultaneously hydrogen and in formula (II) R is not hydrogen,
wherein the glass transition temperature of the organic matrix material is at least 120°C and the highest occupied molecular orbital (HOMO) of the matrix material lies at a maximum energy level of 5.4 eV.

2. Electronic component according to claim 1, **characterized in that** the spiro-bifluorene compound is selected from the group consisting of

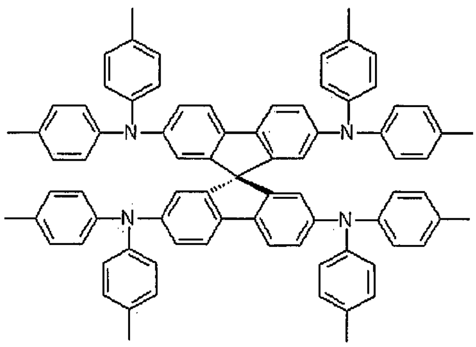

(Spiro-TTB);

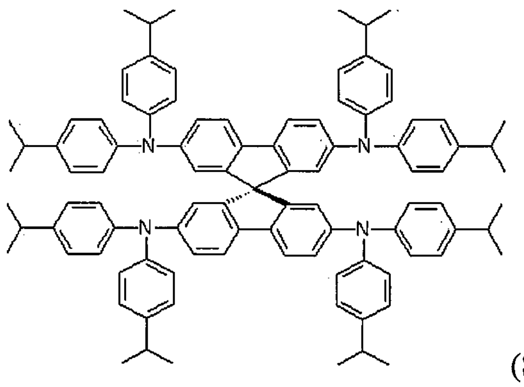

(Spiro-iPr-TAD);

and

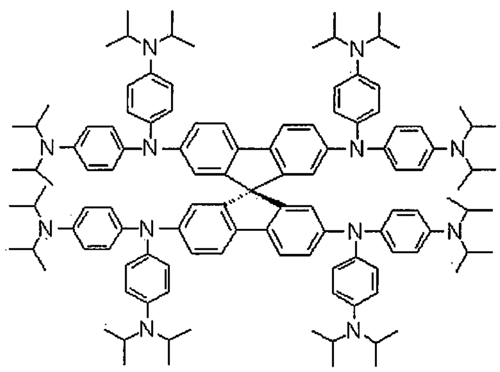

(Spiro-$iPr_2N$-TAD)

3. Electronic component according to claim 1 or 2, **characterized in that** the glass transition temperature of the spiro-bifluorene compound lies between 120°C and 250°C, and the highest occupied molecular orbital of the compound lies at an energy level between 4.5 eV and 5.4 eV, preferably between 4.8 eV and 5.2 eV.

4. Electronic component according to any of the preceding claims, **characterized in that** the dopant is 2,3,5,6-tetrafluoro-7,7,8,8-tetracyano quinodimethane or a derivative thereof.

5. Electronic component according to any of the preceding claims, **characterized in that** the molar doping ratio of dopant to matrix material is between 1:1 and 1:10,000.

## Revendications

1. Composant électronique sous forme d'une diode électroluminescente organique (OLED) ou d'une cellule solaire organique comportant un composant semi-conducteur organique lequel contient une couche de transport de trous constituée d'un matériau matrice organique dopé au moyen d'un dopant organique, **caractérisé en ce que** le matériau matrice organique est au moins partiellement entouré d'un composé spiro-fluorène de formule (I)

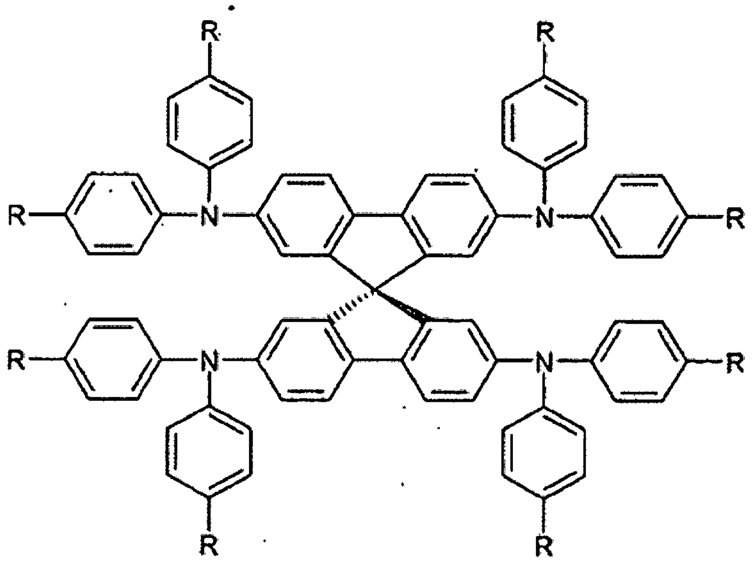

(I ; R-Spiro-TAD)

et/ou de formule (II)

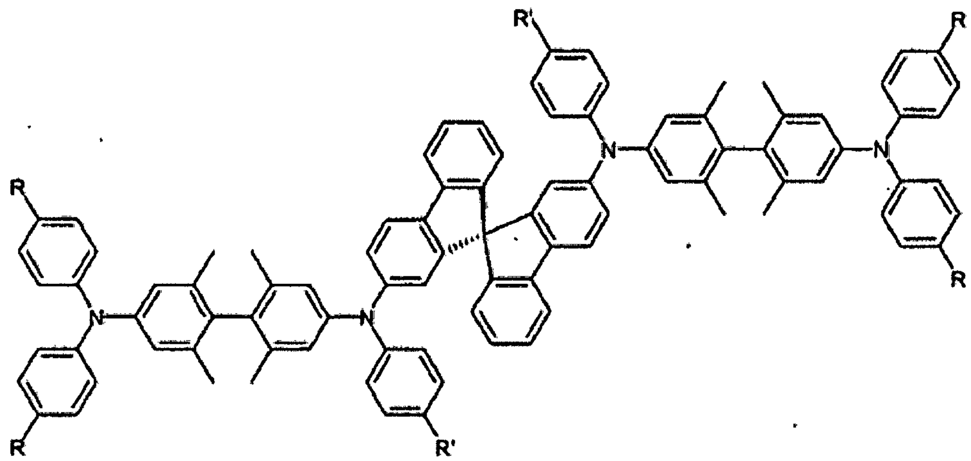

(II ; Spiro-TM-TAD)

chacun des R et/ou R' dans la formule (I) et la formule (II) étant indépendamment choisi dans le groupe constitué d'hydrogène, méthyle, éthyle, n-propyle, iso-propyle, n-butyle, iso-butyle, tert.-butyle, $NH_2$, $N(CH_3)_2$ et de $NPh_2$, à condition que, dans la dans la formule (I), les R ne représentent pas tous simultanément hydrogène et, dans la formule (II), R ne représente pas hydrogène,
la température de transition vitreuse du matériau matrice organique étant supérieure ou égale à 120 °C et le niveau d'énergie de l'Orbitale Haute Occupée (HO) du matériau matrice étant inférieure ou égale à 5,4 eV.

2. Composant électronique selon la revendication 1, **caractérisé en ce que** ledit composé spiro-fluorène est choisi

dans le groupe constitué de

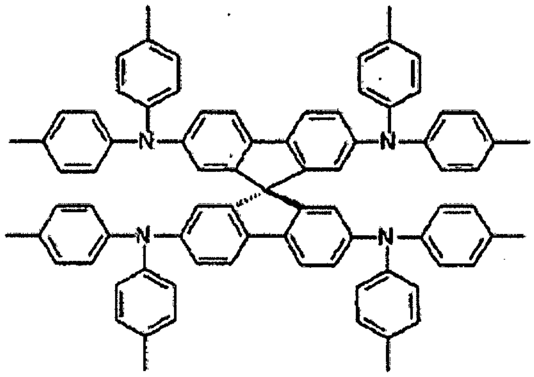

(Spiro-TTB);

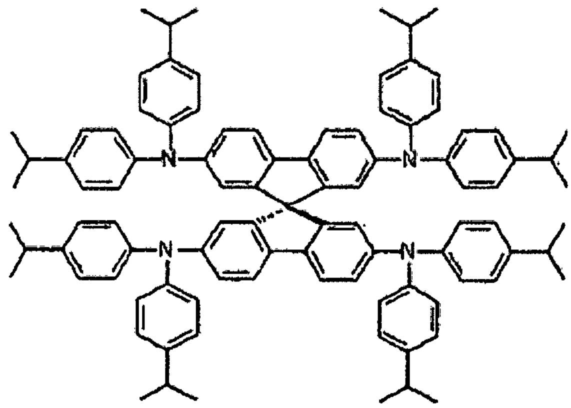

(Spiro-iPr-TAD);

et

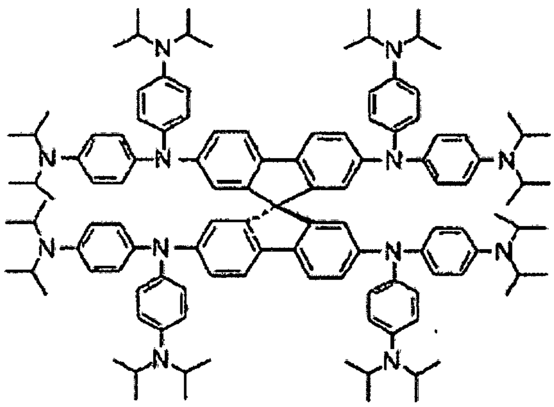

(Spiro-iPr$_2$N-TAD)

**3.** Composant électronique selon les revendications 1 ou 2, **caractérisé en ce que** la température de transition vitreuse dudit composé spiro-fluorène est comprise entre 120 °C et 250 °C et le niveau d'énergie de l'Orbitale Haute Occupée dudit composé est compris entre 4,5 eV et 5,4 eV, de préférence entre 4,8 eV et 5,2 eV.

**4.** Composant électronique selon l'une des revendications précédentes, **caractérisé en ce que** le dopant est le 2,3,5,6-tétrafluoro-7,7,8,8-tétracyanoquinodiméthane ou un dérivé de celui-ci.

**5.** Composant électronique selon l'une des revendications précédentes, **caractérisé en ce que** le rapport molaire de dopage entre le dopant et le matériau matrice est compris entre 1 : 1 et 1 : 10 000.

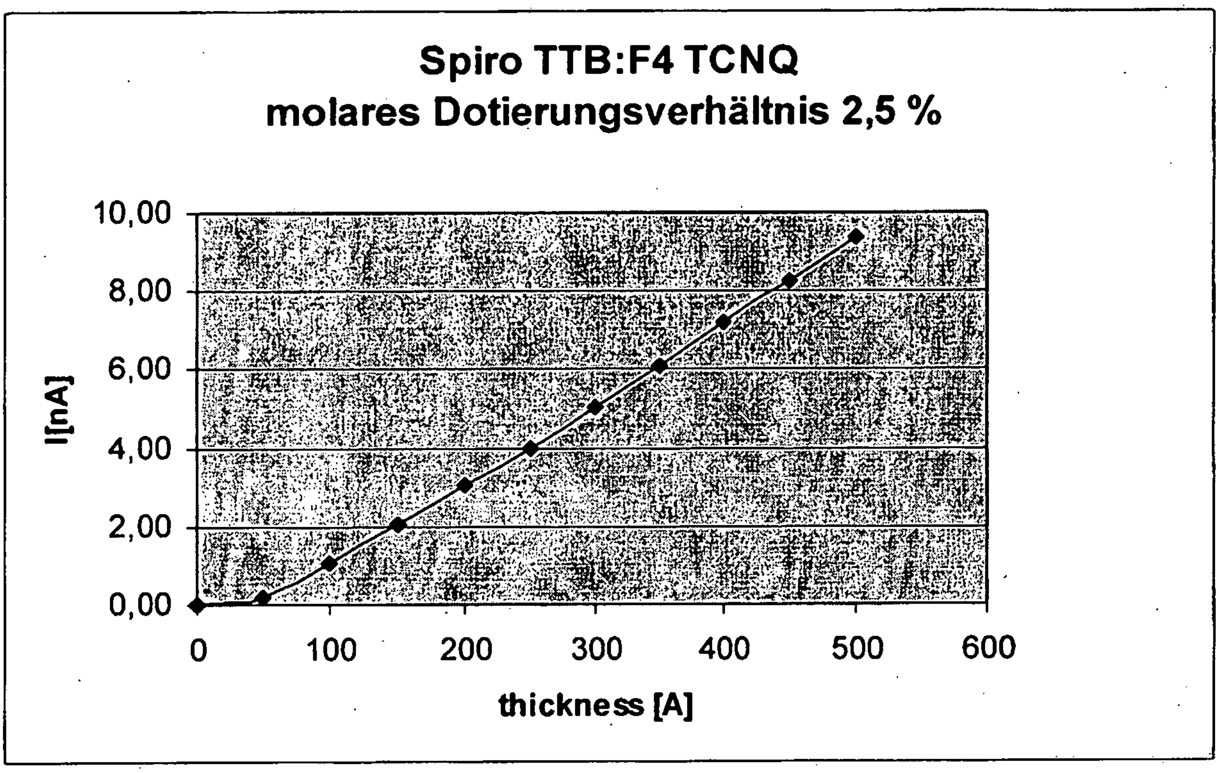
Spiro TTB:F4 TCNQ
molares Dotierungsverhältnis 2,5 %
10,00
8,00
6,00
4,00
2,00
0,00
I[nA]
0
100
200
300
400
500
600
thickness [A]

Fig. 1

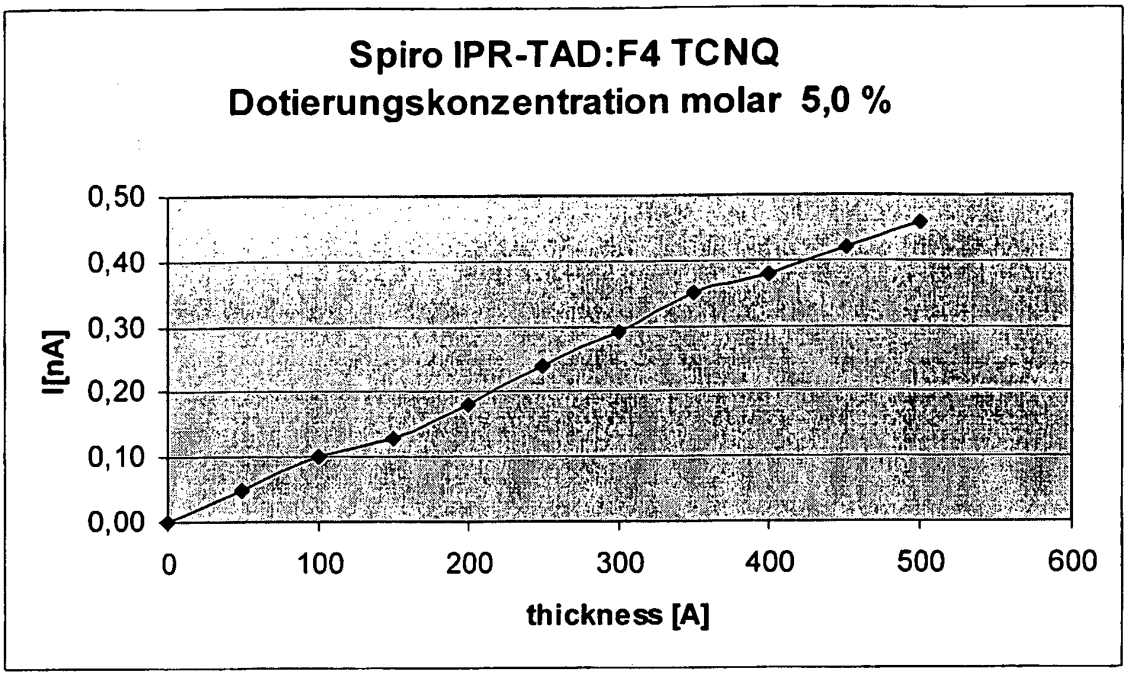
Spiro IPR-TAD:F4 TCNQ
Dotierungskonzentration molar 5,0 %
0,50
0,40
0,30
0,20
0,10
0,00
I[nA]
0
100
200
300
400
500
600
thickness [A]

Fig 2

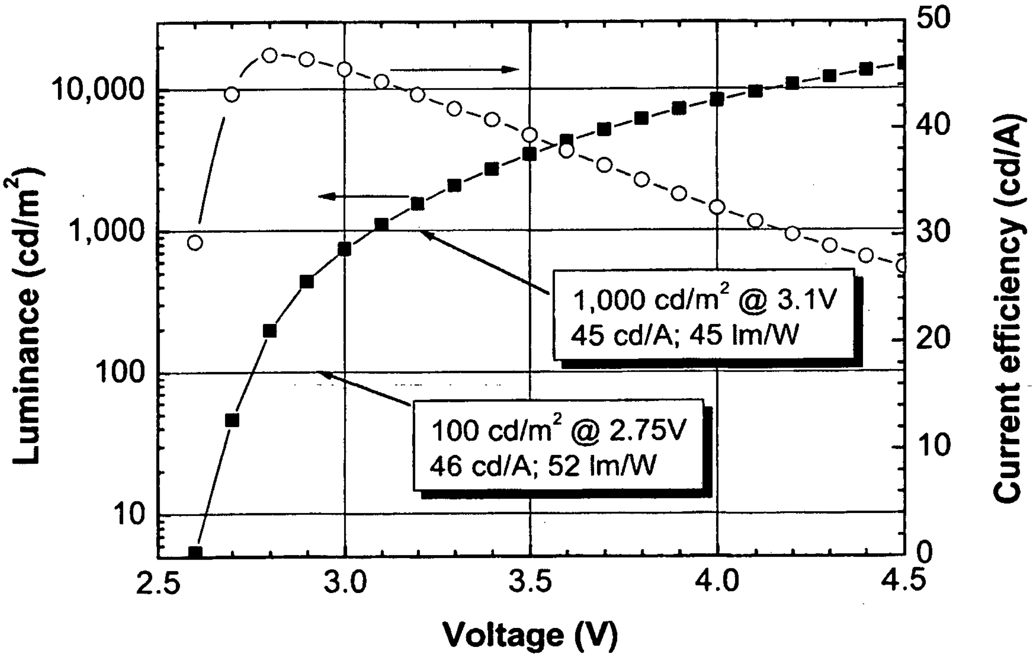
10,000
1,000
100
10
Luminance (cd/m²)
50
40
30
20
10
0
Current efficiency (cd/A)
2.5
3.0
3.5
4.0
4.5
Voltage (V)
1,000 cd/m² @ 3.1V
45 cd/A; 45 lm/W
100 cd/m² @ 2.75V
46 cd/A; 52 lm/W

Fig.3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 6747287 B1
- DE 10357044


### In der Beschreibung aufgeführte Nicht-Patentliteratur


- **M. PFEIFFER ; A. BEYER ; T. FRITZ ; K. LEO.** *Appl.Phys.Lett.,* 1998, vol. 73 (22), 3202-3204
- **J. BLOCHWITZ ; M. PFEIFFER ; T. FRITZ ; K. LEO.** *Appl.Phys.Lett.,* 1998, vol. 73 (6), 729-732
- **X. ZHOU et al.** *Adv. Func. Mater.,* 2001, vol. 11, 310-314
- **L.S. HUNG et al.** *Mater. Sci. Eng.,* 2002, vol. 39, 143-222
- **U. BACH et al.** *Nature,* 1998, vol. 395, 583-585
- **DYALL.** *Aus. J. Chem.,* 1964, vol. 17, 419